Europäisches Patentamt

European Patent Office

Office européen des brevets

(11) Publication number: **0 389 169**
**A2**

# EUROPEAN PATENT APPLICATION

(21) Application number: **90302714.2**

(22) Date of filing: **14.03.90**

(51) Int. Cl.⁵: **H01L 23/08**

(30) Priority: **14.03.89 GB 8905853**

(43) Date of publication of application:
**26.09.90 Bulletin 90/39**

(84) Designated Contracting States:
**AT BE CH DE DK ES FR GB GR IT LI LU NL SE**

(71) Applicant: **OXLEY DEVELOPMENTS CO., LTD.
Priory Park
Ulverston Cumbria LA12 9QG(GB)**

(72) Inventor: **Chambers, Jeffrey
41, Devonshire Road
Ulverston, Cumbria, LA12 9AL(GB)**

(74) Representative: **Huntingford, David Ian et al
W.P. THOMPSON & CO. Coopers Building
Church Street
Liverpool L1 3AB(GB)**

(54) Ceramic multilayer package.

(57) A multilayer ceramic package comprising laminations of a glass-ceramic material, the preferred example of which is an $MgO-Al_2O_3-SiO_2$ ceramic. A ceramic structure comprising a heatsink layer and a ceramic layer made of a glass-ceramic material is assembled in an unfired state and this structure is then fired. Conductor patterns can be screen printed on the unsintered glass ceramic layer, using gold or copper metallisation pastes, permitting the whole assembly to be fired in a single operation.

EP 0 389 169 A2

# CERAMIC MULTILAYER PACKAGE

Hermetic packages provide the necessary environmental protection for the semiconductor to ensure reliable, long term operation. Packages are usually manufactured using high purity, co-fired alumina (see GB 2182923) as the dielectric material. This manufacturing route has its disadvantages, namely the high temperature (approximately 1600°C) at which the alumina co-fires (sinters) and the relatively high proportion of hydrogen required in the furnace atmosphere for correct sintering. Additionally, alumina exhibits a thermal coefficient of expansion (TCE) of 6.7 ppm/K, whereas that of silicon is 2.6 ppm/K. Thus alumina is not an optimum package medium for larger silicon die.

In accordance with a first aspect of the present invention, a multilayer ceramic package adapted to protect a semiconductor comprises a glass-ceramic material.

The thermal coefficient of expansion of the glass-ceramic material is more compatible with that of silicon semiconductors and metal heatsinks than are conventionally-used alumina ceramics. Also, the use of the glass-ceramic allows the multilayer ceramic package to be screen printed with metallisation pastes in an unsintered state, as opposed to the prior art constructions where this was not possible.

Preferably, the glass-ceramic material comprises an $MgO-Al_2O_3-SiO_2$ ceramic. By varying the constituents of the ceramic, the thermal coefficient of expansion of the ceramic material may be matched to any material in the range of from 0 to 18 ppm/K and its constituents offer excellent adhesion to suitably processed metals. Thus, whereas previously it was necessary to select the metal forming a heatsink to be compatible with the thermal coefficient of expansion of the alumina ceramic, it is possible with the present invention to tailor the thermal coefficient of expansion characteristics of the ceramic to be compatible with the preferred metal, as long as its thermal coefficient of expansion lies the above-mentioned range.

The use of glass-ceramic material also permits punching and filling of vertical conductive vias in the green (unsintered) state for the efficient grounding of, for example, a package lid seal ring.

The present invention thus allows selection of a metal with a better TCE match to silicon and attach this to the alumina package structure for direct mounting of the semiconductor onto the metal. This has the advantage of offering a package with a heatsink, capable of dissipating the power generated by the die. However, the disadvantages to this method are the additional processing steps involved it the brazing operating, and the inherent TCE mismatch between the alumina and the metal heatsink which could lead to long term reliability problems.

In accordance with a second aspect of the present invention, a ceramic structure is assembled in an unfired state with a heatsink layer and a ceramic layer, and the structure is then fired.

This produces an inherently hermetic package.

Preferably, the ceramic used is a glass-ceramic structure, preferably an $MgO-Al_2O_3-SiO_2$ ceramic, as gold and copper metallisation pastes are compatible with the glass-ceramic, thus allowing package features such as conductor patterns to be screen printed onto the unsintered ceramic, permitting the whole assembly to be fired in a single firing operation.

The assembly may further comprise a wall structure which is also assembled in the unsintered state. Alternatively, a wall structure e.g. a plastics wall, may be added subsequently to a sintered structure.

In accordance with a further aspect of the present invention, a method of forming a ceramic multilayer package comprises screen-printing conductor patterns on an unsintered glass-ceramic substrate and co-firing the screen-printed substrate with a heatsink layer.

Preferably, the glass-ceramic comprises an $MgO-Al_2O_3-SiO_2$ glass ceramic, which allows such screen printing in an unsintered state. The method may include the co-firing of a ceramic wall portion on top of the screen-printed ceramic layer.

The present invention also includes a method of forming a ceramic multilayer package, comprising screen-printing conductor patterns on an unsintered $MgO-Al_2O_3-SiO_2$ glass-ceramic substrate, assembling the unsintered glass-ceramic substrate with a heatsink layer and co-firing the assembly.

By way of example only, a specific embodiment of the present invention will now be described, with reference to the accompanying drawings, in which:-

Fig. 1 is an exploded schematic perspective view of a multilayer ceramic package assembly in accordance with the present invention;

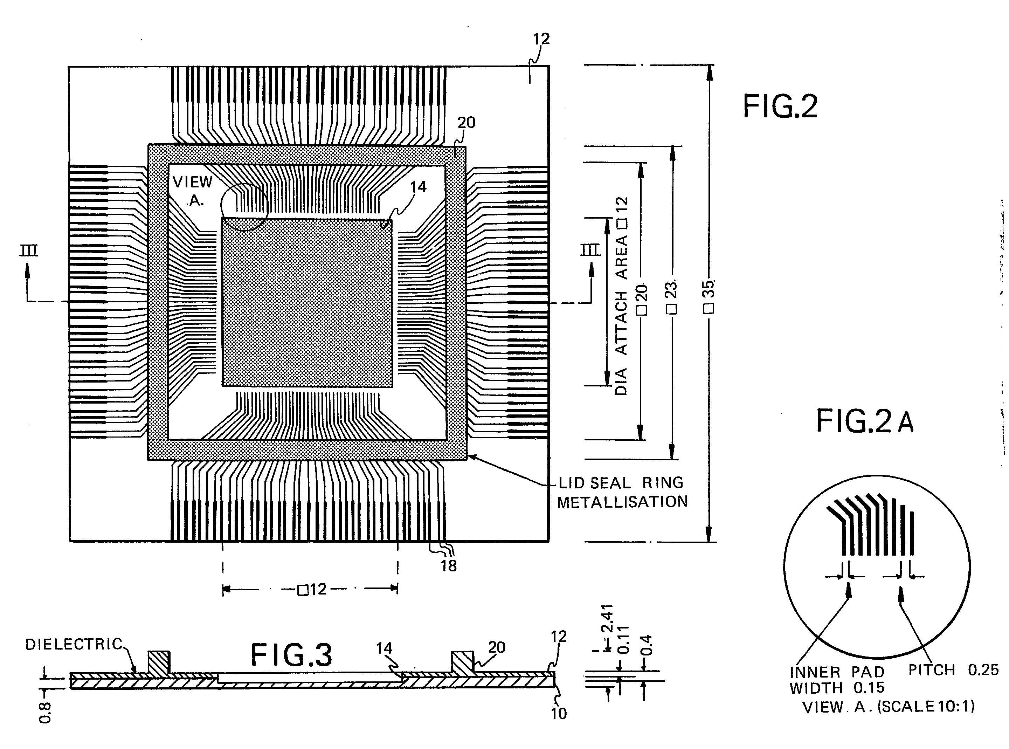

Fig. 2 is a more detailed plan view of the multilayer package assembly of Fig. 1; and

Fig. 3 is a cross-sectional side view along III-III of Fig. 2.

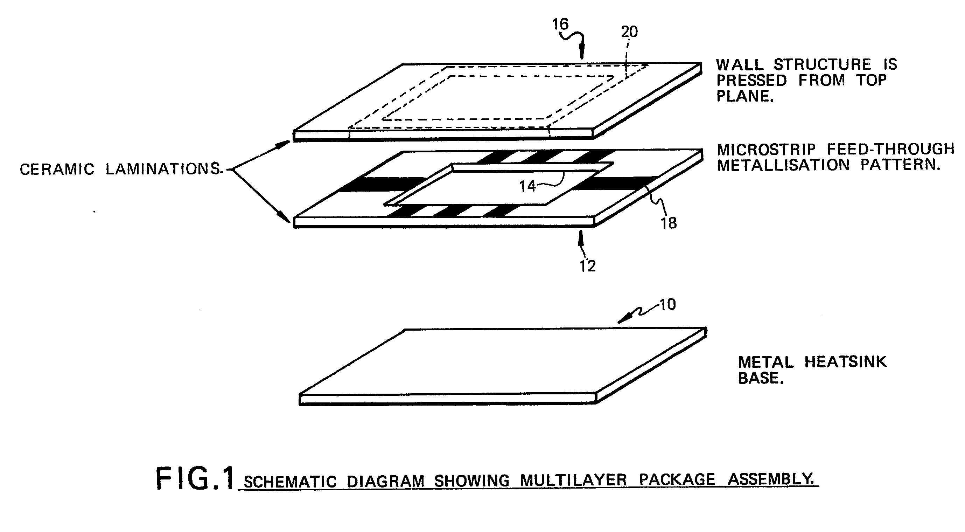

Referring firstly to Fig. 1, a molybdenum heatsink base 10 is provided with a multilayer glass-ceramic laminated layer 12 having a central aperture 14 to receive a semiconductor die, and an upper multilayer glass-ceramic laminated layer 16 is located on the layer 12. The glass-ceramic ma-

terial comprises an $MgO-Al_2O_3-SiO_2$ material, and in this case the constituents are varied to match its thermal coefficient of expansion to that of the molybdenum heatsink base 10.

The laminated ceramic layers 12, 16 are tape cast in various thicknesses, and the central layer is screen-printed with conductor patterns 18. The screen printing is done with gold or copper metallisation pastes, which are conveniently compatible with the unsintered glass-ceramic material. The upper layer 16 is cast as a layer, but a rectangular wall 20, shown in dotted lines in Fig. 1, is pressed from the layer. The multilayer assembly is assembly in the unsintered state, with the heatsink base 10, the central screen-printed ceramic layer 12 and the upper rectangular wall structure 20, and is then fired at a temperature of 900°C to form a fully densified, homogenous, hermetic ceramic structure which is bonded to the metal heatsink.

Subsequent operations are cutting the structure to the required size, and screen printing the upper surface of the wall 20 with metal as before, in order to allow convenient attachment of a lid seal. The use of the $MgO-Al_2O_3-SiO_2$ glass ceramic permits the screen printing which may, if desired be carried out before the firing operation takes place.

As an alternative, the metal heatsink 10 and the first ceramic layer 12 (with its screen-printed conductor tracks) can be co-fired, and a moulded plastics wall structure, replacing the ceramic wall 20, may be attached in a subsequent operation.

## Claims

1. A multilayer ceramic package adapted to protect a semiconductor and comprising a glass-ceramic material.

2. A multilayer ceramic package as claimed in claim 1, wherein said glass-ceramic material is an $MgO-Al_2O_3-SiO_2$ ceramic.

3. A method of forming a ceramic structure in which a heatsink layer and a ceramic layer made of a glass-ceramic material are assembled in an unfired state and the structure is then fired.

4. A method as claimed in claim 3, wherein the glass-ceramic material is an $MgO-Al_2O_3-SiO_2$ ceramic.

5. A method as claimed in claim 3 or 4, wherein conductor patterns are screen printed, using gold or copper metallisation pastes, onto the unsintered ceramic layer, whereby to permit the whole assembly to be fired in a single firing operation.

6. A method as claimed in claim 3, 4 or 5, wherein a wall structure is assembled on said ceramic layer when the ceramic layer is in the unsintered state.

7. A method as claimed in claim 3, 4 or 5, wherein a wall structure is added to said ceramic layer subsequent to said ceramic layer being sintered.

8. A method of forming a ceramic multilayer package comprising screen printing conductor patterns on an unsintered glass-ceramic substrate and co-firing the screen printed substrate with a heatsink layer.

9. A method as claimed in claim 8, wherein the glass-ceramic substrate comprises an $MgO-Al_2O_3-SiO_2$ glass ceramic.

10. A method as claimed in claim 9, including the step of co-firing a ceramic wall portion on top of the screen printed glass-ceramic substrate.

11. A multilayer ceramic package formed by the method of any of claims 3 to 10.

12. A multilayer ceramic package substantially as hereinbefore described with reference to and as illustrated in the accompanying drawings.

WALL STRUCTURE IS PRESSED FROM TOP PLANE.

MICROSTRIP FEED-THROUGH METALLISATION PATTERN.

CERAMIC LAMINATIONS.

METAL HEATSINK BASE.

FIG.1 SCHEMATIC DIAGRAM SHOWING MULTILAYER PACKAGE ASSEMBLY.

EP 0 389 169 A2

# FIG.2

VIEW .A.

20

14

12

III

III

DIA ATTACH AREA □ 12

□ 20

□ 23

□ 35

LID SEAL RING
METALLISATION

18

□ 12

# FIG.3

DIELECTRIC

14

20

12

2.41
0.11
0.4

0.8

10

# FIG.2 A

INNER PAD
WIDTH 0.15

PITCH 0.25

VIEW . A . (SCALE 10:1)

EP 0 389 169 A2